# EUROPEAN PATENT SPECIFICATION

(11) **EP 3 790 200 B1**
(45) Date of publication and mention of the grant of the patent: **18.11.2026**
(21) Application number: 20205008.4
(22) Date of filing: 20.11.2015
(51) Int. Cl.: B41J 2/175, H03M 7/30, G06F 16/174, G06F 40/146, G06F 40/154, G06F 40/123, G06F 40/143, G06F 16/81, G06F 16/84, G06F 3/12

(54) **PRINT MATERIAL CONTAINER COMPRISING MEMORY STORING COMPRESSED XML AND PRINTER EXTRACTING THE XML TO CONTROL AN OPERATION**
DRUCKMATERIALBEHÄLTER MIT EINEM SPEICHER, DER KOMPRIMIERTES XML SPEICHERT, UND DRUCKER, DER DAS XML, ZUR AUSFÜHRUNG EINER AKTION, EXTRAHIERT
CONTENEUR DE MATÉRIEL D'IMPRESSION COMPRENANT UNE MÉMOIRE STOCKANT DES DONNÉES XML COMPRIMÉES ET IMPRIMANTE EXTRAYANT LE XML POUR CONTRÔLER UNE OPÉRATION

(43) Date of publication of application: 10.03.2021
(60) Divisional application: 25178146.4 / 4 621 599
(62) Document number(s) of the earlier application(s) in accordance with Art. 76 EPC: 15908976.2 / 3 377 987
(73) Proprietor: Hewlett-Packard Development Company, L.P., Spring, TX 77389 (US)
(72) Inventor: SANCHEZ RIBES, Salvador, 08174 Sant Cugat del Valles (ES); CASTANO ASPAS, Jorge, 08174 Sant Cugat del Valles (ES)
(74) Representative: Plasseraud IP

(56) References cited:
- EP-A1- 1 610 228
- WO-A1-2010/050037
- WO-A1-2015/016863
- US-A1- 2002 127 020
- US-A1- 2008 133 557
- US-A1- 2011 157 647
- US-A1- 2012 268 782
- US-A1- 2015 153 969
- US-B1- 8 161 199
- TOLANI P M ET AL: "XGrind: a query-friendly XML compressor", PROCEEDINGS 18TH. INTERNATIONAL CONFERENCE ON DATA ENGINEERING. (ICDE'2002). SAN JOSE, CA, FEB. 26 - MARCH 1, 2002; [INTERNATIONAL CONFERENCE ON DATA ENGINEERING. (ICDE)], LOS ALAMITOS, CA : IEEE COMP. SOC, US, vol. CONF. 18, 26 February 2002 (2002-02-26), pages 225 - 234, XP010588214, ISBN: 978-0-7695-1531-1, DOI: 10.1109/ICDE.2002.994712
- SAKR ET AL: "XML compression techniques: A survey and comparison", JOURNAL OF COMPUTER AND SYSTEM SCIENCES, ACADEMIC PRESS, INC., LONDON, GB, vol. 75, no. 5, August 2009 (2009-08-01), pages 303 - 322, XP026054090, ISSN: 0022-0000, [retrieved on 20090203], DOI: 10.1016/J.JCSS.2009.01.004

## Description

### BACKGROUND

Extensible markup language (XML) is used to encode documents in a format readable both by machines and people. Though a document encoded in XML often will not cause a computer to do anything on its own, in combination with an application designed to interpret the XML document, the XML document can cause that application to perform certain functions, display certain information, use certain formatting, and so forth, based on the tags used when encoding the XML document. Consequently, XML standards have been developed to facilitate communication between applications and devices in formats that are agnostic to the specific devices being used. The standards may specify certain keywords or "tags" that will trigger specific functions to be performed. These functions can then be implemented in devices and/or applications in a manner appropriate to that device and/or application.

US 2011/157647 A1 describes a replaceable printer component including a memory and a communication link. The memory is configured to store data in each of a plurality of portions of the memory. Each portion is defined by a tag. Within a first portion of the memory defined by a first tag, the data within the first portion is stored in a plurality of sub-portions of the first portion. Each sub-portion is defined by a sub-tag. The communication link is configured to communicatively link the memory to a printer controller when the replaceable printer component is installed in a printing system.

WO 2015/016863 A1 relates to print containers storing printer operation instructions and includes pointers towards the use of XML for storing said instructions. It shows a print container comprising a supply of print material (e.g. ink), a print material distributer and a memory storing instructions that define actions to be performed by a printer into which the print container is to be installed and thereby control an operation of that printer.

EP 1610228 A1 describes a converter that extracts, from description tag data described in a markup language, a character string representing a tag name, a character string representing an attribute, and a character string representing an attribute value included in the description tag data for conversion into other character string shorter than that character string. A viewer obtains conversion tag data, which is converted tag data, having an amount of data smaller than that of the original description tag data, and creates display data based on the conversion tag data in a viewer body for display on a display device.

P.M. Tolani et al., "XGRIND: A query friendly XML compressor", Proceedings of the 18th International Conference on Data Engineering (ICDE'02), 2002, pages 225-234, XP010588214, supports queries in the compressed domain, and that the compressed format retains the structure of the original document, permitting reuse of the standard XML techniques for processing the compressed document.
P. Skibinski et al., "Effective asymmetric XML compression", Software - Practice and Experience, vol. 38, 2008, pages 1027-1047, XP002563159, describes a XML word-replacing transform including disctionary-based encoding of both document structure and content, separation of different content types into multiple streams, and dedicated encoding of specific patterns, including numbers and dates.
D. Salomon et al., Handbook of Data Compression, 5th edition, Springer-Verlag, 2010, pages 329-334, XP093270460, describes dictionary-based data compression.

### BRIEF DESCRIPTION OF THE DRAWINGS

The present application may be more fully appreciated in connection with the following detailed description taken in conjunction with the accompanying drawings, in which like reference characters refer to like parts throughout, and in which:
FIG. 1 illustrates example files and data structures associated with XML file condensing.
FIG. 2 illustrates a flowchart of example operations associated with XML file condensing.
FIG. 3 illustrates another flowchart of example operations associated with XML file condensing.
FIG. 4 illustrates an example print container associated with XML file condensing.
FIG. 5 illustrates an example printer associated with XML file condensing.
FIG. 6 illustrates another example printer associated with XML file condensing.
FIG. 7 illustrates an example printer in which example systems, and methods, and equivalents, may operate.

### DETAILED DESCRIPTION

The present invention is defined by the features of a print container according to claim 1. A preferred embodiment of the print container is defined in dependent claim 2.

Systems, methods, and equivalents associated with extensible markup language (XML) file condensing are described. In various examples it may be desirable to store XML files on devices or items that do not have a large amount of available memory. These items may be designed to be low cost, and therefore it may be impractical to include larger memory storage space without impacting the cost of producing these items. For example, print containers (e.g., ink cartridges) are a mass market item and pricing of the containers may be competitive, and therefore employing memory resources with excessive space may be wasteful and unnecessarily expensive.

Consequently, an XML file stored on a print container may be condensed in a manner that facilitates reducing the memory impact of the XML file. Though it may take some time for a printer to decondense the file when the print container is installed in the printer, this processing time may be negligible considering that much of the time involved with printing revolves around moving mechanical components of the printer.

Consequently, a manner of condensing an XML file for storing these XML files is disclosed. Ultimately, the XML file is stored as a set of indexes and a condensed version of the XML file. The indexes may be created by dividing the text of the XML file into three types of indexes: tags, attributes, and values. The XML file may then be translated according to the indexes. The indexes and the condensed XML file are then stored in a print container. When the print container is inserted into a printer, the printer may decondense the condensed XML file into the original XML file using the indexes, allowing the printer to use the XML file to perform actions described in the XML file.

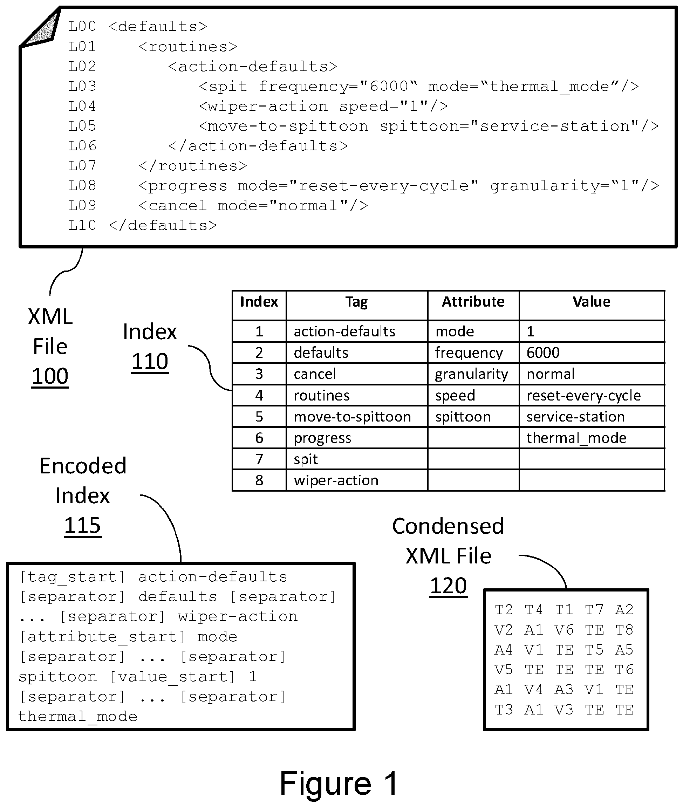

Figure 1 illustrates example files and data structures associated with XML file condensing. It should be appreciated that the items depicted in Figure 1 are illustrative examples and many different files, data structures, techniques for condensing an XML file, and so forth may operate in accordance with various examples. Figure 1 illustrates an XML file 100. XML file 100 is illustrated as having eleven lines labeled L00 through L10. XML file 100 illustrated here is made up of three element types: tags, attributes, and values.

As used herein, tags generally refer to instructions that define an action to be performed. In XML file 100, for example, "<defaults>", "<spit .../>" and "<routines>" are examples of tags. Tags may include other nested tags. Two tag syntaxes are illustrated in XML file 100. The "<defaults>" tag opens on L00 and ends on L10 with a closing tag "</defaults>", while the "<spit .../>" tag begins and ends on the same line. In this example, each tag is illustrated on a different line for illustrative purposes, though multiple tags could be written on the same line.

Tags may also include attributes. In XML file 100, "mode", "frequency", and "granularity" are examples of attributes. As used herein, an attribute of a tag is used to specify a parameter of the unique action triggered by that tag. Further, the attributes may be assigned values. In XML file 100, "1", "normal" and "thermal_mode" are examples of values. As used herein, values are used in association with attributes to specify the parameter of the unique action triggered by a tag the attribute is modifying. By way of illustration, the "<wiper-action .../>" tag has a "speed" attribute that is set to the value "1". Using the "speed" attribute with the "<wiper-action .../>" tag in this way may cause the action associated with the "<wiper-action .../>" tag to behave in a certain way. For example, the "<wiper-action .../>" tag may cause wipers associated with a printer to turn on, and the "speed" attribute may be used to define the speed at which the wipers will operate, which in this case is "1".

To facilitate certain condensation and compression techniques described above, it may be desirable for XML file 100 to have a specific known set of syntaxes. This set of syntaxes may be a subset of possible XML syntaxes. For example, though XML might support values having space characters in them, it may be desirable to ensure that values in XML file 100 use underscores or dashes instead of space characters (e.g., the "thermal_mode" value in line L03, "action-defaults" in line L02). Using a subset of syntaxes may make it easier and/or more efficient to condense, compress, decompress, and decondense XML file 100 by making it easier to ensure that there is not collision due to two phrases having two different syntaxes compressing to the same compressed phrase.

As discussed above, it may be desirable to store XML file 100 in a condensed format. Though XML file 100 as illustrated may be short enough that condensation would be unwarranted, for longer XML files that contain more thorough instructions with more repetition of tags, attributes, and values, condensation may be desirable. To condense XML file 100, first an index 110 may be created. This may be achieved by identifying the tags, attributes, and values in XML file 100 and separating them into their separate categories. Here, XML file 100 includes 8 tags, 5 attributes, and 6 values. In various examples, it may be desirable to further sort the tags attributes and values to assist in condensation and/or a later compression pass of XML file 100. Here, tags, attributes and values are sorted first by their term frequency, and then alphabetically. For example, the "mode" attribute appears in lines L03, and L09, while the "frequency" attribute appears only in line L03. Similarly, tag "<defaults>" appears in lines L00 and L10, while tag "<progress .../> appears only in line L08.

Though one method of indexing the tags, attributes, and values is shown, others may be used instead. By way of illustration, in index 110, the tags, attributes, and values all use the same range of index numbers 1-8. In other examples, indexes may be designed instead where the tags, attributes, and values are each assigned non-overlapping index ranges. Other index assignments may also be appropriate.

Once index 110 has been created, encoding of the index into encoded index 115 and condensation of XML file 100 into condensed XML file 120 may begin. In figure 1, one possible version of encoded index 115 is shown. Bracketed items may represent specialized identifiers in encoded index 115 that are used to indicate separation between components of index 110. In one example, the separators may be, for example, characters such as spaces, punctuation, a combination, known values, and so forth. In example encoded index 115, 5 separators are used: "[tag_start]" which indicates a beginning of the tag index, "[attribute_start]" which indicates the beginning of the attribute index, "[value_start]" which indicates the beginning of the value index, "[separator]" which indicates separation between components of index 110, and "[index_end]" which indicates the end of encoded index 115. In cases where encoded index 115 and condensed XML file 120 are stored as a single item, the "[index_end]" separator may also indicate the beginning of condensed XML file 120. Further, some of the separators may be represented by the same specialized identifiers.

As discussed above, in the example index 110 illustrated, tags, attributes, and values each use the same index range, and that index range begins from a known value. Consequently, encoded index 115 may not need to identify index values of the tags, attributes, and keys within encoded index 115. Instead, this information may be reconstructed as a part of a process of decondensing condensed XML file 120. In example implementations where tags, attributes, and values are assigned varying indexes, this information may also be stored in encoded index 115.

To create condensed XML file 120, XML file 100 may be translated according to index 110. Here, XML file 100 has been translated so that each pair of characters (e.g., "T2") in condensed XML file 120 corresponds to a specific tag, attribute, or value of XML file 100. This correspondence can be seen by examining index 110. Specifically, the first "<defaults>" tag is identified as having index 2 in index 110. Thus, the first T2 of condensed XML file 120 corresponds to the first "<defaults>" tag in XML file 100 because it is tag (indicated by the T) number 2 in index 110. Similarly, the phrase "<spit frequency="6000" mode="thermal_mode"/>" from line LO3 of XML file 100 corresponds to the portion of condensed XML file 120 that reads "T7 A2 V2 A1 V6 TE" that spans the first and second lines of condensed XML file 120. It is worth noting that condensed XML file 120 and encoded index 115 may have more or fewer characters depending on how these items are created, including additional symbols that could serve a variety of purposes.

In this example version of condensed XML file 120, a specialized symbol indicating a tag end is used. This symbol, represented as "TE", is used to indicate to an application interpreting condensed XML file 120, that the most recent open tag here should be closed. By way of illustration, the very last "TE" in condensed XML file 120 corresponds to the close of the "</defaults>" tag on line L10 of XML file 100. In various examples, using the TE tag may be desirable because certain forms of compression are more efficient the more that characters repeat. This is also a reason why sorting the tag index by term frequency is useful, as increased usage of the same indexes can further increase compression efficiency.

Consequently, once XML file 100 has been condensed into encoded index 115 and condensed XML file 120, the combination of which will be referred to as a translated file, the translated file may be further reduced in size by employing a compression technique. Which compression technique is used may depend on how encoded index 115 and condensed xml file 120 are created as the creation of these items may be designed to be optimal for a specific data compression technique.

Whether the translated file has been further compressed or not, the translated file may then be stored on a memory of an item with which XML file 100 is associated. One item where this type of condensation of XML file 100 is desirable is a print container containing a supply of print material. The print material and/or the print container may be designed to work with a specific type of printer. The printer may be two dimensional printers ranging such as a desktop printer designed for home or office use, an industrial scale printers that can output thousands of items per hour, and so forth. The printer could also be a three-dimensional printer. As mentioned above, these techniques involving condensing XML files may also be applied outside of the printing field.

Depending on the type of printer with which the print container is associated with, the print material may include ink, toner, cleaning fluid, build material for a 3D printer, and so forth. Thus XML file 100 contains instructions for the printer into which the print container is installed. These instructions may tell the printer how to operate efficiently using the print material. Consequently, these instructions may be related to cleaning the printer, otherwise servicing the printer, printing using the print material, and so forth. Other information could be conveyed to the printer in this manner, (e.g., security information, general updates).

Once the print container is installed into a printer, that printer may retrieve the translated file from the memory of the print container, and then begin decompressing, and decondensing the translated file back into XML file 100. How the file is decompressed will depend on the compression technique used. Decondensing the translated file may operate in reverse of creating the condensed XML file. Because syntaxes may be limited to a known set of syntaxes, XML file 100 may be recreated by filling in the syntaxes based on the specific ordering of tags, attributes, and values in condensed XML file 120. After decondensing the translated file back into XML file 100, the printer may then use the instructions to perform a function described by XML file 100 (e.g., cleaning the printer, servicing the printer, printing using a material in the print container).

In some examples, after decompressing and decondensing the translated file back into XML file 100, the printer may combine the instructions from XML file 100 with a set of stored instructions. These stored instructions may be a set of default instructions that the printer may use regardless of which print material is installed, unless overwritten by an instruction from an XML file such as XML file 100.

"Module", as used herein, includes but is not limited to hardware, firmware, software stored on a computer-readable medium or in execution on a machine, and/or combinations of each to perform a function(s) or an action(s), and/or to cause a function or action from another module, method, and/or system. A module may include a software controlled microprocessor, a discrete module, an analog circuit, a digital circuit, a programmed module device, a memory device containing instructions, and so on. Modules may include gates, combinations of gates, or other circuit components. Where multiple logical modules are described, it may be possible to incorporate the multiple logical modules into one physical module. Similarly, where a single logical module is described, it may be possible to distribute that single logical module between multiple physical modules.

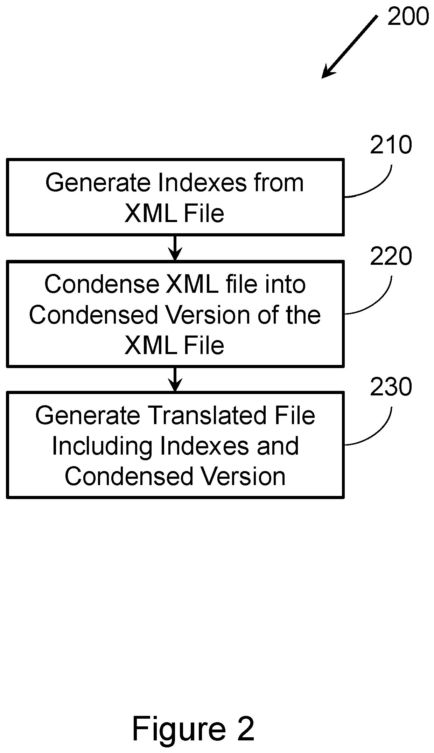

Figure 2 illustrates an example method 200 associated with XML file condensing. Method 200 may be embodied on a non-transitory computer-readable medium storing processor-executable instructions. The instructions, when executed by a processor, may cause the processor to perform method 200. In other examples, method 200 may exist within logic gates and/or RAM of an application specific integrated circuit.

Method 200 includes generating indexes from an extensible markup language (XML) file at 210. In various examples, the XML file may contain instructions that control operation of a printer. The XML file may contain instructions that control operation of the printer based on a type of printing material stored in a printing material container (e.g., ink cartridge). By way of illustration, different materials may affect components of a printer in different manners and may cause those components to have different maintenance needs. Thus, an XML file associated with a print container storing a particular print material may be able to control the printer to perform various functions, including maintenance functions, suitable for the particular print material. The XML file may also include other instructions related to, for example, cleaning the printer, servicing the printer, printing using the printing material, and so forth.

The set of indexes includes several indexes including a tag index, an attribute index, and a value index. The tag index indexes tag terms used in the XML file. The attribute index indexes attribute terms in the XML file. The value index indexes value terms in the XML file. The terms in the tag index, attribute index, and value index are ordered within their respective indexes according to the frequency of the terms within the XML file. Ordering the indexes according to term frequencies may be desirable because certain compression techniques achieve greater compression rates the more terms are repeated. Consequently, when index ranges overlap, the repeated use of these indexes may help achieve greater compression rates.

The XML file contains instructions that control operation of a printer. The XML file may contain instructions that control operation of the printer based on a type of printing material stored in a printing material container (e.g., ink cartridge). By way of illustration, different materials may affect components of a printer in different manners and may cause those components to have different maintenance needs. Thus, an XML file associated with a print container storing a particular print material may be able to control the printer to perform various functions, including maintenance functions, suitable for the particular print material. The XML file may also include other instructions related to, for example, cleaning the printer, servicing the printer, printing using the printing material, and so forth.

Method 200 also includes condensing the XML file into a condensed version of the XML file at 220. The condensed version of the XML file may be condensed by translating the XML file according to the indexes. In some examples, to facilitate creation of the indexes at 210, condensation of the XML file at 220, and the potential decondensation of the XML file at a later point, the XML file uses a known subset of XML syntaxes. These syntaxes may be preselected so that, for example, for any two given different XML statements, the condensed version of these two statements be different. Similarly, the syntaxes may also be selected so that for any two given different condensed statements, decondensed versions of these statements will also be different.

Method 200 also includes generating a translated file. The translated file may be made up of the set of indexes created at action 210, and the condensed version of the XML file created at action 220. By way of illustration, the indexes and the condensed version of the XML file may be concatenated into a single file to create the translated file.

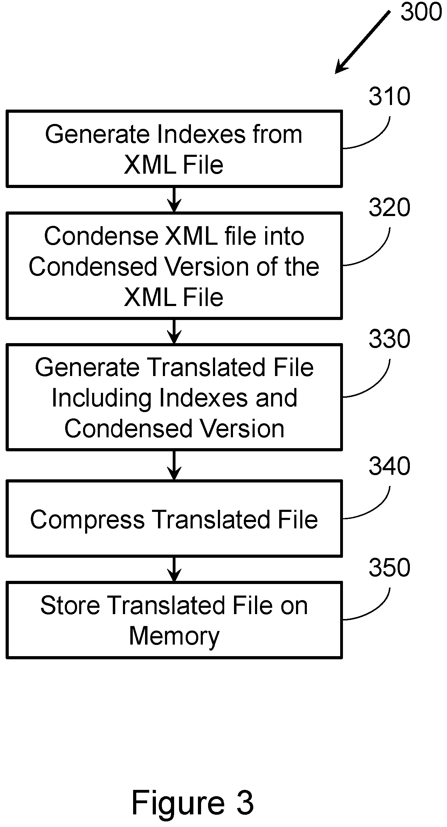

Figure 3 illustrates a method 300 associated with XML file condensing. Method 300 includes several actions similar to those described above with reference to method 200 (figure 2). For example, method 300 includes generating a set of indexes from an XML file at 310, condensing the XML file into a condensed version of the XML file at 320, and generating a translated file including the set of indexes and the condensed version of the XML file at 330.

Method 300 also includes compressing the translated file at 340. Compressing the translated file may further reduce the total file size of the translated file. Method 300 also includes storing the translated file on a memory at 350. Where the XML file contains instructions that control operation of a printer in association with a printing material, the translated file is stored on a memory of a printing material container that holds a supply of printing material. This may allow a printer to be specifically configured for using a variety of printing materials without having to store this information in the printer itself. This may be desirable when, for example, configuring the printer to use a new printing material, saving memory space within the printer, and so forth.

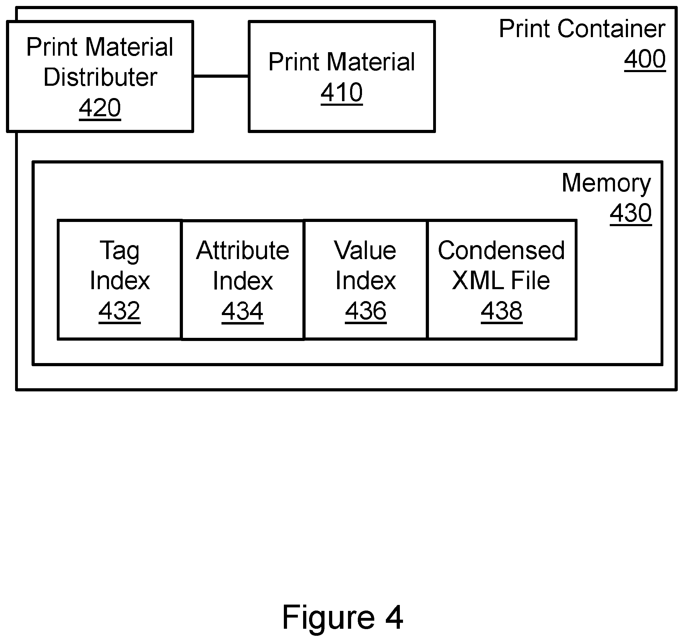

Figure 4 illustrates a print container 400 associated with extensible markup language (XML) file condensing. Print container 410 includes a supply of print material 410. Print material 410 may be, for example, ink, cleaning fluid, and so forth. Print container 400 also includes a print material distributer 420. Print material distributer 420 may take many forms depending on how a printer into which print container 400 is inserted is designed to operate. For example, if the printer draws print material 410 from print container 400 to be ejected onto a print media at another location, print material distributer 420 may interface with a mechanism of the printer that draws the print material 410 from print container 400. Alternatively, if print container is a cartridge designed to directly eject print material 410 onto a print media, print material distributer 420 may directly distribute print material 410.

Print container also includes a memory 430. Memory 430 includes a tag index 432. Tag index 432 contains a list of tag terms from an extensible markup language (XML) file. The tag terms are organized according to the frequency of the tag terms in the XML file. Memory 430 also includes an attribute index 434. Attribute index 434 contains a list of attribute terms from the XML file. The attribute terms are organized in attribute index 434 according to the frequency of the attribute terms in the XML file. Memory 430 also includes a value index 436. Value index 436 contains a list of value terms from the XML file. The value terms are organized in value index 436 according to the frequency of the value terms in the XML file.

Memory 430 also includes a condensed XML file 438. Condensed version of the XML file 438 may be created by translating the XML file according to the tag index, the attribute index and the value index. Tag index 432, attribute index 434, value index 436, and condensed XML file 438 are stored in memory 430 in a compressed format. In various examples, a printer into which print container 400 is inserted may use the tag index, the attribute index, the value index, and the condensed version of the XML file to recreate the XML file. Consequently, the recreated XML file controls an operation of the printer in association with one or more of, print material 410, print container 400, print material distributer 420, and so forth.

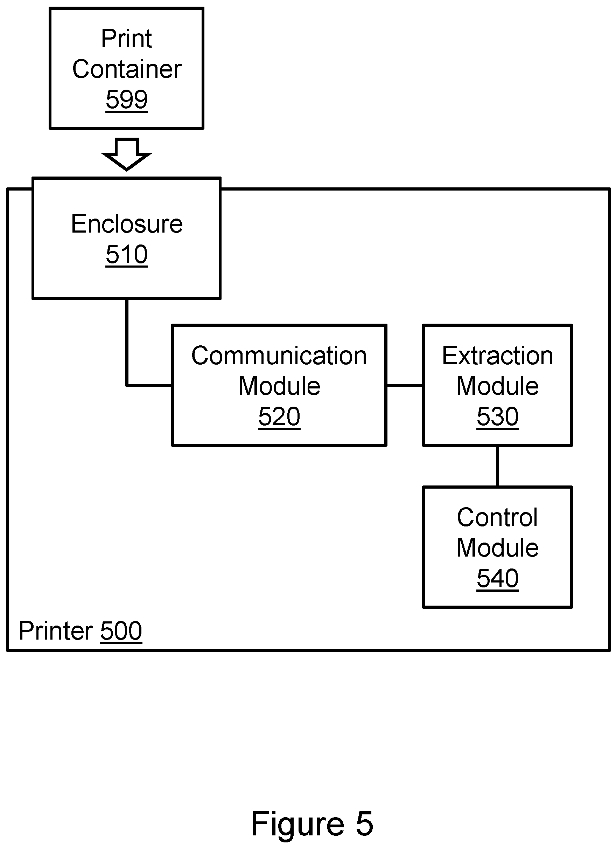

Figure 5 illustrates a printer 500 associated with extensible markup language (XML) file condensing. Printer 500 includes an enclosure 510. Enclosure 510 may receive a print container 599 having a supply of print material. The print material may be, for example, ink, toner, cleaning fluid, and so forth.

Printer 500 also includes a communication module 520. Communication module 520 may obtain a set of indexes and a condensed XML file from print container 599. The condensed XML file may have been created from the set of indexes as well as an original XML file that is not stored on print container 599. In various examples, communication module 520 may retrieve the set of indexes and condensed XML file from a memory on print container 599. Consequently, in this example, enclosure 510 and print container 599 may contain appropriate electronic couplings to facilitate communication between communication module 520 and the memory on print container 599.

Printer 500 also includes an extraction module 530. Extraction module 530 may generate a decondensed XML file. The decondensed XML file may be generated by translating the condensed XML file according to the set of indexes.

Printer 500 also includes a control module 540. Control module 540 may control an operation of printer 500 according to instructions retrieved from the decondensed XML file. In various examples, control module 540 may control one or more of, cleaning a component of the printer, servicing a component of the printer, printing using the print material contained in print container 599, and so forth.

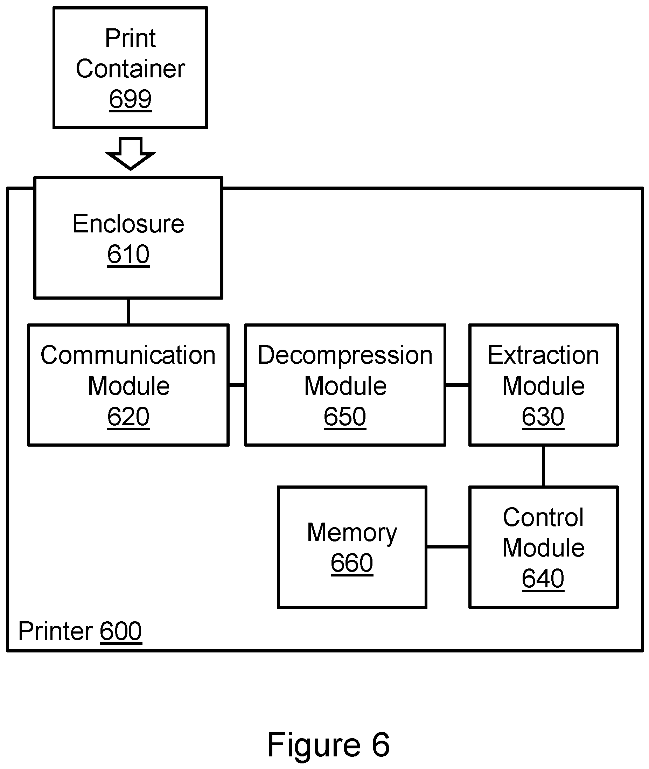

Figure 6 illustrates a printer 600 associated with XML file condensing. Printer 600 includes several items similar to those described above with reference to printer 500. For example, printer 600 includes an enclosure 610 to receive a print container 699 having a supply of print material, a communication module 620, an extraction module 630, and a control module 640.

Printer 600 also includes a decompression module 650. Decompression module 650 may decompress the set of indexes and the condensed XML file. Decompression of the condensed XML file and the indexes may be performed when these items are stored on a memory of print container 699 in a compressed format to further reduce the amount of data stored on print container 699.

Printer 600 also includes a memory 660. Memory 660 may store a set of default instructions. Consequently, control module 640 may control the operation of the printer according to instructions retrieved from the decondensed XML file when the decondensed XML file modifies the default instructions. As discussed above, the operation of the printer may relate to cleaning the printer, servicing the printer, printing using the print material, and so forth.

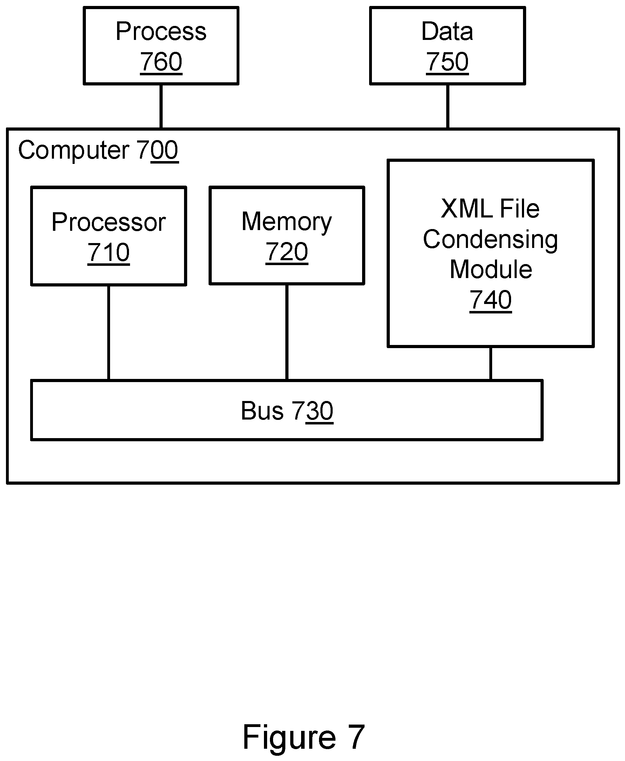

Figure 7 illustrates an example computer in which example systems and methods, and equivalents, may operate. The example computer may include components such as a processor 710 and a memory 720 connected by a bus 730. Computer 700 also includes an XML file condensing module 740. XML file condensing module 740 may perform, alone or in combination, various functions described above with reference to the example systems, methods, apparatuses, and so forth. In different examples, XML file condensing module 740 may be implemented as a non-transitory computer-readable medium storing processor-executable instructions, in hardware, software, firmware, an application specific integrated circuit, and/or combinations thereof.

The instructions may also be presented to computer 700 as data 750 and/or process 760 that are temporarily stored in memory 720 and then executed by processor 710. The processor 710 may be a variety of processors including dual microprocessor and other multi-processor architectures. Memory 720 may include non-volatile memory (e.g., read only memory) and/or volatile memory (e.g., random access memory). Memory 720 may also be, for example, a magnetic disk drive, a solid state disk drive, a floppy disk drive, a tape drive, a flash memory card, an optical disk, and so on. Thus, memory 720 may store process 760 and/or data 750. Computer 700 may also be associated with other devices including computers, printers, peripherals, and so forth in numerous configurations (not shown).

It is appreciated that the previous description of the disclosed examples is provided to enable any person skilled in the art to make or use the present disclosure.

## Claims

1. A print container (400), comprising:
a supply of a print material (410);
a print material distributer (420); and
a memory (430) storing:
a tag index (432) containing a list of tag terms from an extensible markup language, XML, file containing instructions that control an operation of a printer and using a known subset of XML syntaxes, the tag index being organized according to a frequency of the tag terms in the XML file, where a tag term of the tag index refers to an instruction defining an action to be performed by the printer into which the print container is to be installed;
an attribute index (434) containing a list of attribute terms from the XML file organized according to a frequency of the attribute terms in the XML file, where an attribute term of the attribute index is used to specify a parameter of the action triggered by the tag term;
a value index (436) containing a list of value terms from the XML file organized according to a frequency of the value terms in the XML file, where a value term of the value index is used in association with the attribute term to specify the parameter of the action triggered by the tag term the attribute term is to modify; and
a condensed version of the XML file (120, 438) containing only pairs of characters and specialized symbols (TE) indicating that a most recent open tag should be closed, wherein each of the pairs of characters (T2) corresponds to a specific tag, attribute, or value of the XML file, wherein a first portion of each of the respective pairs of characters identifies the tag index, the attribute index, or the value index, and a second portion of each of the respective pairs of characters identifies a index value in the tag index, the attribute index, or the value index, wherein the tag index, the attribute index, the value index, and the condensed version of the XML file are stored in the memory in a compressed format.

2. The print container of claim 1, where the XML file is associated with the print container storing a particular print material and where the XML file is to control the printer to perform a maintenance function suitable for the particular print material.

## Patentansprüche

1. Druckbehälter (400), der umfasst:
einen Vorrat an einem Druckmaterial (410);
einen Druckmaterialverteiler (420); und
einen Speicher (430), der speichert:
einen Tag-Index (432), der eine Liste von Tag-Begriffen aus einer Datei einer erweiterbaren Auszeichnungssprache, XML-Datei, enthält, die Anweisungen enthält, die einen Betrieb eines Druckers steuern, und eine bekannte Untergruppe von XML-Syntaxen verwendet, wobei der Tag-Index gemäß einer Frequenz der Tag-Begriffe in der XML-Datei organisiert ist, wobei sich ein Tag-Begriff des Tag-Index auf eine Anweisung bezieht, die eine Aktion definiert, die durch den Drucker durchzuführen ist, in den der Druckbehälter zu installieren ist;
einen Attributindex (434), der eine Liste von Attributbegriffen aus der XML-Datei enthält, die gemäß einer Frequenz der Attributbegriffe in der XML-Datei organisiert ist, wobei ein Attributbegriff des Attributindex verwendet wird, um einen Parameter der Aktion, die durch den Tag-Begriff ausgelöst wird, zu spezifizieren;
einen Wertindex (436), der eine Liste von Wertbegriffen aus der XML-Datei enthält, die gemäß einer Frequenz der Wertbegriffe in der XML-Datei organisiert ist, wobei ein Wertbegriff des Wertindex in Verbindung mit dem Attributbegriff verwendet wird, um den Parameter der Aktion, die durch den Tag-Begriff ausgelöst wird, den der Attributbegriff modifizieren soll, zu spezifizieren; und
eine verdichtete Version der XML-Datei (120, 438), die nur Zeichenpaare und spezialisierte Symbole (TE) enthält, die angeben, dass ein zuletzt geöffnetes Tag geschlossen werden soll, wobei jedes der Zeichenpaare (T2) einem spezifischen Tag, Attribut oder Wert der XML-Datei entspricht, wobei ein erster Teil jedes der jeweiligen Zeichenpaare den Tag-Index, den Attribut-Index oder den Wert-Index identifiziert, und ein zweiter Teil jedes der jeweiligen Zeichenpaare einen Indexwert in dem Tag-Index, dem Attribut-Index oder dem Wert-Index identifiziert, wobei der Tag-Index, der Attribut-Index, der Wert-Index und die verdichtete Version der XML-Datei in dem Speicher in einem komprimierten Format gespeichert sind.

2. Druckbehälter nach Anspruch 1, wobei die XML-Datei mit dem Druckbehälter verbunden ist, der ein bestimmtes Druckmaterial speichert, und wobei die XML-Datei dazu dient, den Drucker zu steuern, um eine für das bestimmte Druckmaterial geeignete Wartungsfunktion durchzuführen.

## Revendications

1. Récipient d'impression (400), comprenant :
un approvisionnement en un matériau d'impression (410) ;
un distributeur de matériau d'impression (420) ; et
une mémoire (430) stockant :
un index de balises (432) contenant une liste de termes de balise provenant d'un fichier de langage de balisage extensible, XML, contenant des instructions qui commandent un fonctionnement d'une imprimante et utilisant un sous-ensemble connu de syntaxes XML, l'index de balises étant organisé selon une fréquence des termes de balise dans le fichier XML, où un terme de balise de l'index de balises fait référence à une instruction définissant une action à effectuer par l'imprimante dans laquelle le récipient d'impression doit être installé ;
un index d'attributs (434) contenant une liste de termes d'attribut du fichier XML organisée selon une fréquence des termes d'attribut dans le fichier XML, où un terme d'attribut de l'index d'attributs est utilisé pour spécifier un paramètre de l'action déclenchée par le terme de balise ;
un index de valeurs (436) contenant une liste de termes de valeur provenant du fichier XML organisée selon une fréquence des termes de valeur dans le fichier XML, où un terme de valeur de l'index de valeurs est utilisé en association avec le terme d'attribut pour spécifier le paramètre de l'action déclenchée par le terme de balise que le terme d'attribut doit modifier ; et
une version condensée du fichier XML (120, 438) contenant uniquement des paires de caractères et des symboles spécialisés (TE) indiquant qu'une balise ouverte la plus récente doit être fermée, dans laquelle chacune des paires de caractères (T2) correspond à une balise, un attribut ou une valeur spécifique du fichier XML, dans laquelle une première partie de chacune des paires de caractères respectives identifie l'index de balise, l'index d'attribut ou l'index de valeur, et une seconde partie de chacune des paires de caractères respectives identifie une valeur d'index dans l'index de balise, l'index d'attribut ou l'index de valeur, dans lequel l'index de balise, l'index d'attribut, l'index de valeur et la version condensée du fichier XML sont stockés dans la mémoire dans un format compressé.

2. Récipient d'impression selon la revendication 1, où le fichier XML est associé au récipient d'impression stockant un matériau d'impression particulier et où le fichier XML est destiné à commander l'imprimante pour exécuter une fonction de maintenance appropriée pour le matériau d'impression particulier.
